# EUROPEAN PATENT APPLICATION

(11) **EP 4 730 926 A1**
(43) Date of publication of application: **22.04.2026**
(21) Application number: 25207193.1
(22) Date of filing: 07.10.2025
(51) Int. Cl.: H05K 1/183, H04B 1/40, H05K 1/02, H05K 3/28, H05K 3/46

(54) **SYSTEMS AND METHODS FOR SEMICONDUCTOR PACKAGING USING PRINTED CIRCUIT BOARD (PCB) CAVITY INTEGRATION**

(30) Priority: 21.10.2024 US 202418921596
(71) Applicant: Avago Technologies International Sales Pte. Limited, Singapore 768923 (SG)
(72) Inventor: Choi, Chang Kyu, Fremont, CA, 94536 (US); Sun, Li, San Jose, CA, 95148 (US); Haney, Sarah Kay, San Jose, CA, 95112 (US); Wade, Christopher Paul, Los Gatos, CA, 95032 (US); Leary, Michael Howard, Sunnyvale, CA, 94087 (US); Chung, Ki Woong, San Jose, CA, 95120 (US)
(74) Representative: Grünecker Patent- und Rechtsanwälte PartG mbB

(57) **Abstract**

The subject technology is directed to a semiconductor device and methods for its fabrication and use. In an embodiment, the subject technology provides a semiconductor device that comprises a substrate having a first side and a second side. The second side comprises a cavity. A first circuit is coupled to the first side of the substrate and is characterized by a first thickness. A second circuit, comprising an RF component, is positioned within the cavity on the second side of the substrate and is characterized by a second thickness greater than the first thickness. The cavity is characterized by a first depth less than or equal to the second thickness. This configuration allows the RF component to be embedded within the substrate, optimizing the device's height and improving space utilization for compact electronic devices. There are other embodiments as well.

## Description

### FIELD OF INVENTION

The subject technology is directed to semiconductor devices.

### BACKGROUND OF THE INVENTION

The increasing demand for compact and efficient electronic devices, such as telecommunications and wireless communication systems, has driven the need for advanced packaging solutions. Devices such as mobile phones and tablets require the integration of multiple circuits, including radio frequency (RF) components, into increasingly compact form factors. These RF components are important for ensuring reliable communication in wireless networks but often present challenges due to their size and thermal dissipation requirements. Some approaches for circuit packaging involve mounting the components on both sides of a printed circuit board (PCB). This can result in increased thickness and inefficient use of available space, particularly for components with varying thicknesses.

Various approaches for circuit integration and thermal management have been explored, but they have proven to be insufficient. It is important to recognize the need for new and improved methods and systems that address the limitations in space utilization, component integration, and heat dissipation.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a schematic cross-sectional view of a semiconductor device, in accordance with various embodiments of the subject technology.
Figure 2 is a schematic cross-sectional view of a semiconductor device, in accordance with various embodiments of the subject technology.
Figure 3 is a schematic cross-sectional view of a semiconductor device, in accordance with various embodiments of the subject technology.
Figure 4 is a schematic cross-sectional view of a semiconductor device, in accordance with various embodiments of the subject technology.
Figure 5 is a schematic cross-sectional view of a semiconductor device, in accordance with various embodiments of the subject technology.

### DETAILED DESCRIPTION OF THE INVENTION

The subject technology is directed to a semiconductor device and methods for its fabrication and use. In an embodiment, the subject technology provides a semiconductor device that comprises a substrate having a first side and a second side. The second side comprises a cavity. A first circuit is coupled to the first side of the substrate and is characterized by a first thickness. A second circuit, comprising an RF component, is positioned within the cavity on the second side of the substrate and is characterized by a second thickness greater than the first thickness. The cavity is characterized by a first depth less than or equal to the second thickness. This configuration allows the RF component to be embedded within the substrate, optimizing the device's height and improving space utilization for compact electronic devices. There are other embodiments as well.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

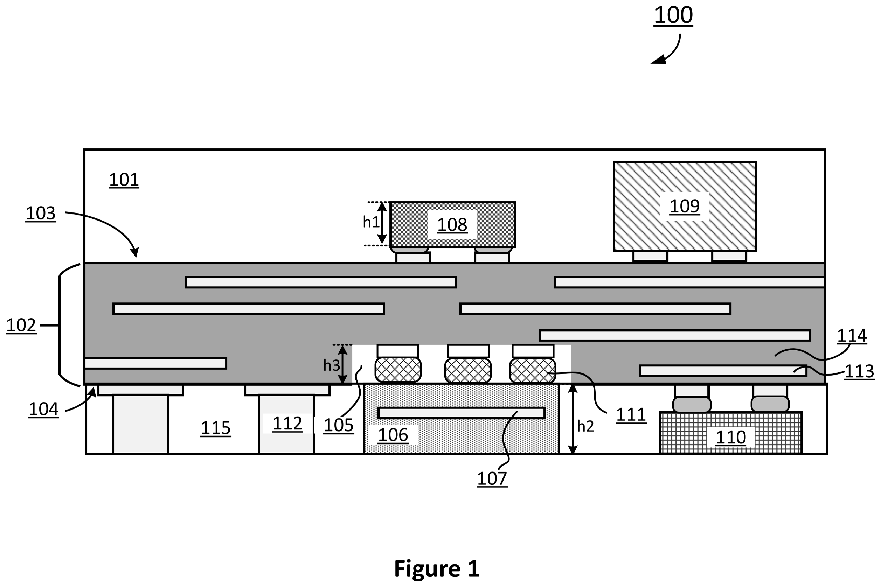

Figure 1 is a schematic cross-sectional view of a semiconductor device 100, in accordance with various embodiments of the subject technology. This diagram merely provides an example, which should not unduly limit the scope of the claims. One of ordinary skill in the art would recognize many variations, alternatives, and modifications. In various implementations, semiconductor device 100 may be a part of, or may include, multiple components that comprise an electronic system such as an integrated circuit (IC), a system-on-chip (SoC), a system-in-package (SiP), a multi-chip module (MCM), and/or the like.

In various implementations, semiconductor device 100 includes substrate 102. For example, the term "substrate" may refer to a base layer that supports and electrically connects the various components of a semiconductor device. Substrate 102 may include, without limitation, printed circuit boards (PCBs), printed wiring boards (PWBs), silicon wafers, ceramic substrates, interposers, and/or the like. For instance, substrate 102 may include a PCB.

Depending on the implementation, substrate 102 may have various configurations, such as single-layer, multi-layer, rigid, or flexible designs. For instance, substrate 102 may include one or more metal layers (e.g., metal layer 113), which may serve as conductive pathways for signal transmission or power distribution. Metal layer 113 may include, without limitation, copper, aluminum, gold, or other conductive materials. These metal layers may be configured to route electrical signals across the substrate and/or to provide power to components mounted on or embedded within the substrate. In some examples, substrate 102 may further include one or more dielectric layers (e.g., dielectric layer 114). Dielectric layer 114 may include, without limitation, ceramic, glass, epoxy resin, polyimide, prepreg, silicon dioxide, metal oxide, and/or the like.

In various implementations, substrate 102 may include first side 103 and second side 104. First side 103 may be positioned opposite second side 104. For purposes of this disclosure, the first side may also be referred to as the top side, upper side, or upper surface. The second side may be referred to as the bottom side, lower side, underside, or backside. These terms are used interchangeably throughout this description to describe various embodiments and are not intended to limit the scope of the subject technology.

Depending on the implementation, first side 103 may serve as the primary surface for the mounting of various circuits and components, such as first circuit 108. In some examples, first circuit 108 may have a relatively thin profile. For instance, first circuit 108 may be characterized by a first thickness (e.g., h1). The thickness of a circuit may refer to the vertical dimension or height of the component, measured from the bottom surface to the topmost surface. In some cases, the first thickness may be less than or equal to 80 um. First circuit 108 may include, without limitation, microcontrollers, logic circuits, memory devices, sensor modules, processing units, and/or the like.

According to some embodiments, semiconductor device 100 may further include second circuit 106, which may be coupled to second side 104. In some examples, second circuit 106 may be characterized by a second thickness (e.g., h2) greater than the first thickness. For instance, the second thickness may be greater than or equal to 80 um. In some cases, second circuit 106 may include seal space gap 107, which provides a buffer or clearance that ensures proper mechanical and functional performance between the internal components of second circuit 106.

In some implementations, second circuit 106 may include a radio frequency (RF) component. The term "RF component" may refer to any electronic component or circuit used in radio frequency applications to process or control RF signals. Examples of RF components may include, without limitation, filter circuits (e.g., bandpass filters, high-pass filters, low-pass filters), bulk acoustic wave (BAW) filters, film bulk acoustic resonators (FBARs), surface acoustic wave (SAW) filters, low noise amplifier (LNA) circuits, transmit filters, receive filters, power amplifiers, and/or the like. These components often require more vertical space due to their operational characteristics, such as higher power dissipation or specific signal processing needs.

Placing second circuit 106 on second side 104 of substrate 102 allows for better utilization of space, reducing the crowding of components on first side 103 and enabling a compact layout. By relocating larger or thicker components, such as RF components, to second side 104, the configuration reduces the horizontal (e.g., X&Y) footprint on first side 103. This allows for more efficient component placement and routing, ultimately leading to a smaller overall package size. Additionally, it helps to separate high-power RF components from other circuits, reducing the risk of signal interference and thermal buildup.

In some examples, second side 104 further includes cavity 105. For instance, the term "cavity" may refer to a recess or depression formed within a structure (e.g., substrate 102). Cavity 105 provides additional vertical space, allowing for the placement of components with greater height, such as second circuit 106, without increasing the overall thickness of semiconductor device 100. Cavity 105 may be formed using various fabrication techniques, such as etching, laser ablation, milling, chemical processing, and/or the like. During fabrication, dielectric layer 114 and metal layer 113 within substrate 102 may be partially removed to form cavity 105, ensuring that the surrounding structure maintains its integrity and electrical performance.

Cavity 105 may be configured in various shapes and depths depending on the dimensions and configuration of the components being housed within it. For example, cavity 105 may be rectangular, circular, oval, triangular, or irregularly shaped to accommodate different form factors and optimize the use of available space. Cavity 105 may be characterized by a first depth (e.g., h3). The term "depth" may refer to the vertical distance between the bottom surface and the top opening of a structure (e.g., a cavity). In some examples, the first depth may be less than or equal to the second thickness of second circuit 106. This configuration allows second circuit 106 to be at least partially embedded within cavity 105, which helps reduce the overall profile of the device and enables the integration of thicker components without significantly increasing the device height.

In various embodiments, the first depth is greater than 20 um and less than 120 um. For instance, cavity 105 may be formed by partially removing the bottom outer dielectric layer (e.g., dielectric layer 114) and the bottom outer metal layer (e.g., metal layer 113). The thickness of the bottom outer dielectric layer may range from 10 um to 40 um. The thickness of the bottom outer metal layer may range from 10 um to 20 um. In some cases, the thickness of these layers determines the depth and structure of cavity 105, ensuring adequate space for embedding circuit components while maintaining the electrical and mechanical integrity of the device.

In some implementations, second circuit 106 may be coupled to substrate 102 via first connection 111. For example, the term "connection" may refer to any structure or mechanism that enables electrical, mechanical, or thermal coupling between two components. Examples of connections may include, without limitation, solder joints, wire bonds, vias, flip-chip bonds, and/or thermally conductive adhesives, and/or the like.

In various embodiments, semiconductor device 100 further includes third circuit 109 coupled to first side 103. Third circuit 109 may include a passive component. For example, the term "passive component" may refer to an electrical component that does not require an external power source to operate. Examples of passive components may include, without limitation, resistors, capacitors, inductors, transformers, and/or the like. In some implementations, the layout of first side 103 may be optimized for compactness and performance, allowing for high-density component placement. However, the available space and height on first side 103 are limited, especially for components with greater thicknesses (e.g., greater than 80 um).

In various embodiments, semiconductor device 100 further includes layer 101, which may be coupled to first circuit 108 and/or third circuit 109. For instance, layer 101 includes a molding material. The term "molding material" may refer to an encapsulating material used to protect and insulate electronic components. Examples of molding materials may include, without limitation, epoxy molding compounds (EMC), silicone molding compounds (SMC), phenolic molding compounds, polyimide molding compounds, and/or the like. Molding materials may be used to encapsulate electronic components (e.g., first circuit 108, third circuit 109), protecting them from physical damage, moisture, dust, and other environmental factors.

In various embodiments, semiconductor device 100 further includes fourth circuit 110 coupled to second side 104. Fourth circuit 110 may include, without limitation, microcontrollers, logic circuits, memory devices, sensor modules, processing units, and/or the like. In some examples, metal post 112 may be coupled to second side 104. For instance, the term "metal post" may refer to a conductive structure used to provide mechanical support, electrical connectivity, or thermal dissipation within a semiconductor device. Metal post 112 may be made from materials such as copper, aluminum, gold, or other conductive metals, depending on the application and the specific requirements of the device.

In various embodiments, semiconductor device 100 further includes layer 115, which may be coupled to second side 104. For instance, layer 115 includes a molding material. Layer 115 provides an encapsulation for components positioned on second side 104 (e.g., second circuit 106, fourth circuit 110, metal post 112). In some implementations, the surface of metal post 112 and the backside of the circuits (e.g., second circuit 106, fourth circuit 110) may be exposed at the same height on a surface of layer 115, enabling direct soldering and improved heat dissipation. Layer 115 ensures that the components on second side 104 are uniformly aligned and mechanically supported, providing protection against environmental factors such as moisture, dust, and contaminants. Additionally, layer 115 facilitates the integration of semiconductor device 100 with external components (e.g., heat sinks or circuit boards) by providing a uniform surface for attachment.

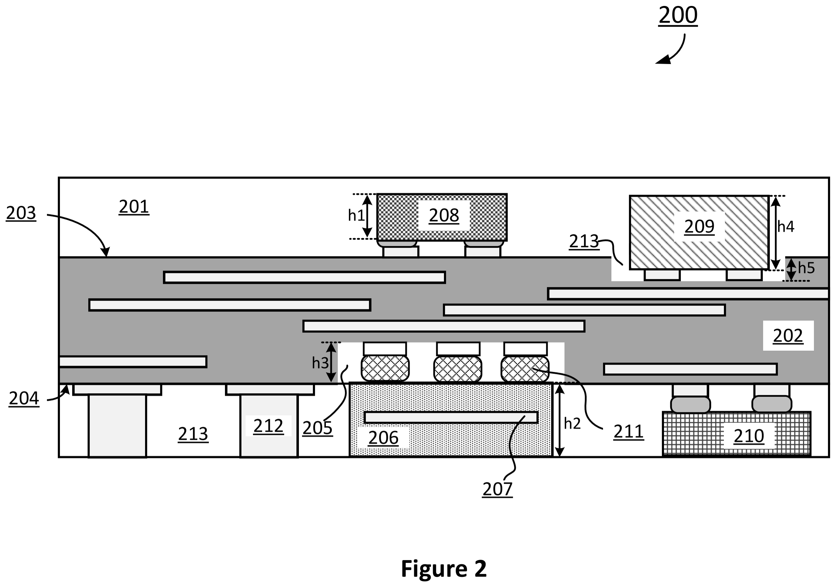

Figure 2 is a schematic cross-sectional view of a semiconductor device 200, in accordance with various embodiments of the subject technology. This diagram merely provides an example, which should not unduly limit the scope of the claims. One of ordinary skill in the art would recognize many variations, alternatives, and modifications. In various embodiments, semiconductor device 200 may include at least one of substrate 202, first circuit 208, second circuit 206, third circuit 209, fourth circuit 210, first cavity 205, second cavity 213, metal post 212, and/or the like.

In some embodiments, semiconductor device 200 includes substrate 202, which may include first side 203 and second side 204. First side 203 may be positioned opposite second side 204. Depending on the implementation, first side 203 may serve as the primary surface for the mounting of various circuits and components, such as first circuit 208. For instance, first circuit 208 may be characterized by a first thickness (e.g., h1), which may be less than or equal to 80 um. First circuit 208 may include, without limitation, microcontrollers, logic circuits, memory devices, sensor modules, processing units, and/or the like.

In various implementations, semiconductor device 200 may further include second circuit 206, which may be coupled to second side 204. Second circuit 206 may include an RF component. In some examples, second circuit 206 may be characterized by a second thickness (e.g., h2) greater than the first thickness. For instance, the second thickness may be greater than or equal to 80 um. In some cases, second circuit 206 may include seal space gap 207, which provides a buffer or clearance that ensures proper mechanical and functional performance between the internal components of second circuit 206.

In some embodiments, second side 204 further includes first cavity 205. Second circuit 206 may be positioned within first cavity 205. First cavity 205 may be characterized by a first depth (e.g., h3), which may be greater than 20 um and less than 120 um. First cavity 205 may be configured to provide additional vertical space, allowing second circuit 206 to be at least partially embedded within substrate 202 without increasing the overall thickness of semiconductor device 200. In some implementations, second circuit 206 may be coupled to substrate 202 via first connection 211. Examples of connections may include, without limitation, solder joints, wire bonds, vias, flip-chip bonds, and/or thermally conductive adhesives, and/or the like.

In various embodiments, semiconductor device 200 further includes third circuit 209 coupled to first side 203. Third circuit 209 may include a passive component. Examples of passive components may include, without limitation, resistors, capacitors, inductors, transformers, and/or the like. In some implementations, third circuit 209 may be characterized by a third thickness (e.g., h4), which may be greater than the first thickness. For instance, the third thickness may be greater than or equal to 80 um. To accommodate the dimensions of third circuit 209, first side 203 may further include second cavity 213. In some examples, second cavity 213 may be characterized by a second depth (e.g., h5), which may be greater than 20 um and less than 120 um. Second cavity 213 may be configured to provide additional vertical space, allowing third circuit 209 to be at least partially embedded within substrate 202.

The inclusion of both first cavity 205 and second cavity 213 in semiconductor device 200 offers design flexibility by enabling the integration of thick components (e.g., second circuit 206 and third circuit 209) while maintaining a compact overall profile. This configuration reduces the overall height of the device and improves space utilization on first side 203. Additionally, the separation of components into dedicated cavities minimizes signal interference and improves thermal management by distributing the components across different areas of substrate 202.

In various embodiments, semiconductor device 200 further includes layer 201, which may be coupled to first circuit 208 and/or third circuit 209. For instance, layer 201 includes a molding material. Layer 201 may be configured to encapsulate electronic components (e.g., first circuit 208, third circuit 209), protecting them from physical damage, moisture, dust, and other environmental factors.

In various embodiments, semiconductor device 200 further includes fourth circuit 210 coupled to second side 204. Fourth circuit 210 may include, without limitation, microcontrollers, logic circuits, memory devices, sensor modules, processing units, and/or the like. In some examples, metal post 212 may be coupled to second side 204 and serve as a thermal or mechanical support structure, facilitating heat dissipation or ensuring the secure placement of components. Metal post 212 may be made from materials such as copper, aluminum, gold, or other conductive metals, depending on the application and the specific requirements of the device.

In various embodiments, semiconductor device 200 further includes layer 213, which may be coupled to second side 204. For instance, layer 213 includes a molding material. Layer 213 provides an encapsulation for components positioned on second side 204 (e.g., second circuit 206, fourth circuit 210, metal post 112), protecting them from physical damage, moisture, dust, and other environmental factors.

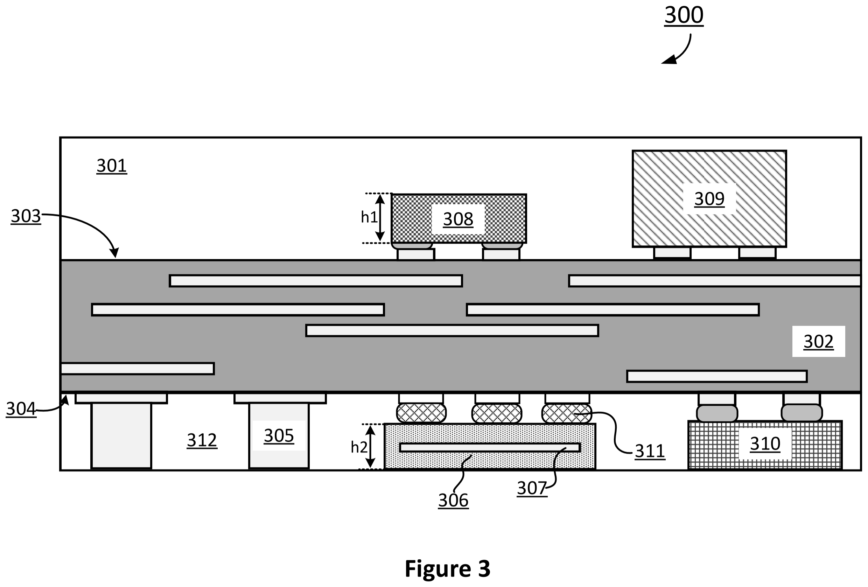

Figure 3 is a schematic cross-sectional view of a semiconductor device 300, in accordance with various embodiments of the subject technology. This diagram merely provides an example, which should not unduly limit the scope of the claims. One of ordinary skill in the art would recognize many variations, alternatives, and modifications. In various embodiments, semiconductor device 300 may include at least one of substrate 302, first circuit 308, second circuit 306, third circuit 309, fourth circuit 310, metal post 305, and/or the like.

In some embodiments, semiconductor device 300 includes substrate 302, which may include first side 303 and second side 304. First side 303 may be positioned opposite second side 304. Depending on the implementation, first side 303 may serve as the primary surface for the mounting of various circuits and components, such as first circuit 308 and/or third circuit 309. For instance, first circuit 308 may be characterized by a first thickness (e.g., h1), which may be less than or equal to 80 um. First circuit 308 may include, without limitation, microcontrollers, logic circuits, memory devices, sensor modules, processing units, and/or the like. Third circuit 309 may include a passive component. Examples of passive components may include, without limitation, resistors, capacitors, inductors, transformers, and/or the like.

In various implementations, semiconductor device 300 may further include second circuit 306, which may be coupled to second side 304. Second circuit 306 may include an RF component. In some examples, second circuit 306 may be characterized by a second thickness (e.g., h2) greater than the first thickness. For instance, the second thickness may be greater than or equal to 80 um. In some cases, second circuit 306 may include seal space gap 307, which provides a buffer or clearance that ensures proper mechanical and functional performance between the internal components of second circuit 306.

In some implementations, second circuit 306 may be coupled to substrate 302 via first connection 311. Examples of connections may include, without limitation, solder joints, wire bonds, vias, flip-chip bonds, and/or thermally conductive adhesives, and/or the like. Placing second circuit 306 on second side 304 of substrate 302 allows for better utilization of space, reducing the crowding of components on first side 303 and enabling a more compact layout. This configuration also supports X&Y size reduction by freeing up valuable real estate on first side 303, resulting in a smaller overall package size. Additionally, it helps to separate high-power RF components from other circuits, reducing the risk of signal interference and thermal buildup.

In various embodiments, semiconductor device 300 further includes layer 301, which may be coupled to first circuit 308 and/or third circuit 309. For instance, layer 301 includes a molding material. Layer 301 may be configured to encapsulate electronic components (e.g., first circuit 308, third circuit 309), protecting them from physical damage, moisture, dust, and other environmental factors.

In various embodiments, semiconductor device 300 further includes fourth circuit 310 coupled to second side 304. Fourth circuit 310 may include, without limitation, microcontrollers, logic circuits, memory devices, sensor modules, processing units, and/or the like. In some examples, metal post 305 may be coupled to second side 304 and serve as a thermal or mechanical support structure, facilitating heat dissipation or ensuring the secure placement of components. Metal post 305 may be made from materials such as copper, aluminum, gold, or other conductive metals, depending on the application and the specific requirements of the device.

In various embodiments, semiconductor device 300 further includes layer 312, which may be coupled to second side 304. For instance, layer 312 includes a molding material. Layer 312 provides an encapsulation for components positioned on second side 304 (e.g., second circuit 306, fourth circuit 310, metal post 305), protecting them from physical damage, moisture, dust, and other environmental factors.

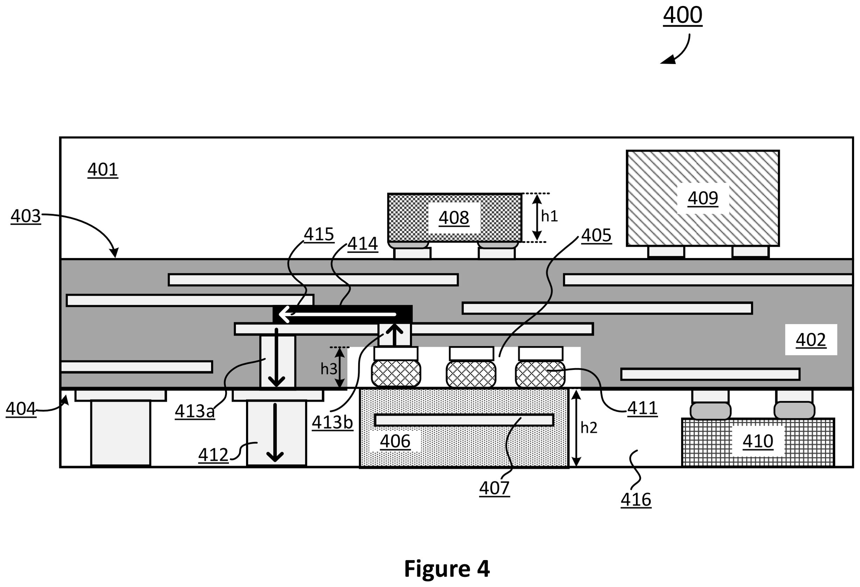

Figure 4 is a schematic cross-sectional view of a semiconductor device 400, in accordance with various embodiments of the subject technology. This diagram merely provides an example, which should not unduly limit the scope of the claims. One of ordinary skill in the art would recognize many variations, alternatives, and modifications. In various embodiments, semiconductor device 400 may include at least one of substrate 402, first circuit 408, second circuit 406, third circuit 409, fourth circuit 410, first cavity 405, metal post 412, and/or the like.

In various implementations, semiconductor device 400 includes substrate 402, which may include first side 403 and second side 404. First side 403 may be positioned opposite second side 404. Depending on the implementation, first side 403 may serve as the primary surface for the mounting of various circuits and components, such as first circuit 408 and/or third circuit 409. For instance, first circuit 408 may be characterized by a first thickness (e.g., h1), which may be less than or equal to 80 um. First circuit 408 may include, without limitation, microcontrollers, logic circuits, memory devices, sensor modules, processing units, and/or the like. Third circuit 409 may include a passive component. Examples of passive components may include, without limitation, resistors, capacitors, inductors, transformers, and/or the like.

In various embodiments, semiconductor device 400 further includes layer 401, which may be coupled to first circuit 408 and/or third circuit 409. For instance, layer 401 includes a molding material. Layer 401 may be configured to encapsulate electronic components (e.g., first circuit 408, third circuit 409), protecting them from physical damage, moisture, dust, and other environmental factors.

In various implementations, semiconductor device 400 may further include second circuit 406, which may be coupled to second side 404. Second circuit 406 may include an RF component. In some examples, second circuit 406 may be characterized by a second thickness (e.g., h2) greater than the first thickness. For instance, the second thickness may be greater than or equal to 80 um. In some cases, second circuit 406 may include seal space gap 407, which provides a buffer or clearance that ensures proper mechanical and functional performance between the internal components of second circuit 406.

In some embodiments, second side 404 further includes first cavity 405. Second circuit 406 may be positioned within first cavity 405. First cavity 405 may be characterized by a first depth (e.g., h3), which may be greater than 20 um and less than 120 um. First cavity 405 may be configured to provide additional vertical space, allowing second circuit 406 to be at least partially embedded within substrate 402 without increasing the overall thickness of semiconductor device 400. In some implementations, second circuit 406 may be coupled to substrate 402 via first connection 411. Examples of connections may include, without limitation, solder joints, wire bonds, vias, flip-chip bonds, and/or thermally conductive adhesives, and/or the like.

In various embodiments, semiconductor device 400 further includes fourth circuit 410 coupled to second side 404. Fourth circuit 410 may include, without limitation, microcontrollers, logic circuits, memory devices, sensor modules, processing units, and/or the like.

In some embodiments, metal post 412 may be coupled to second side 404 and serve as a thermal or mechanical support structure, facilitating heat dissipation or ensuring the secure placement of components. Metal post 412 may be made from materials such as copper, aluminum, gold, or other conductive metals, depending on the application and the specific requirements of the device. In some examples, metal post 412 may serve as a thermal conduit between second circuit 406 and external heat sinks or the ambient environment. Heat generated by second circuit 406, such as in RF applications, can be efficiently routed through metal post 412, which channels the heat away from sensitive components on both first side 403 and second side 404.

In various embodiments, semiconductor device 400 further includes layer 416, which may be coupled to second side 404. For instance, layer 416 includes a molding material. Layer 416 provides an encapsulation for components positioned on second side 404 (e.g., second circuit 406, fourth circuit 410, metal post 412), protecting them from physical damage, moisture, dust, and other environmental factors.

In various implementations, substrate 402 may include one or more vias (e.g., 413a-b and 414). For instance, the term "via" may refer to any conductive path or structure that extends through one or more layers of a substrate, providing electrical, mechanical, or thermal connections between different components or layers. Vias can be used to connect layers vertically or laterally, depending on the configuration. They may facilitate signal routing and thermal dissipation across multiple layers or through different regions within the substrate. Examples of vias may include, without limitation, through-hole vias, blind vias, buried vias, microvias, and/or the like.

In some embodiments, vias 413a and 413b may include vertical vias that extend through one or more layers of substrate 402. Via 413a may be coupled to metal post 412, facilitating the transfer of heat from the internal components of the device to external heat dissipation structures, such as a heat sink or ambient environment. Via 413b may be coupled to second circuit 406 through connection 411, facilitating electrical or thermal communication between second circuit 406 and other components or layers. These vertical vias enable efficient routing of signals between different layers of the substrate and also provide pathways for heat dissipation, directing heat away from second circuit 406.

In various examples, via 414 may include a lateral via that provides lateral or horizontal connectivity within substrate 402. Via 414 may provide electrical connections between different components located on the same or adjacent layers within substrate 402, allowing for efficient signal transmission and thermal dissipation without taking up additional surface area. In some cases, via 414 may assist in distributing heat laterally. For example, via 414 may connect vertical vias 413a and 413b, forming a continuous thermal path 415 that conducts heat from second circuit 406 to metal post 412. This configuration facilitates efficient thermal management by leveraging both lateral and vertical pathways to route heat away from high-power components (e.g., second circuit 406), thereby reducing the risk of thermal hotspots and maintaining optimal device performance and longevity.

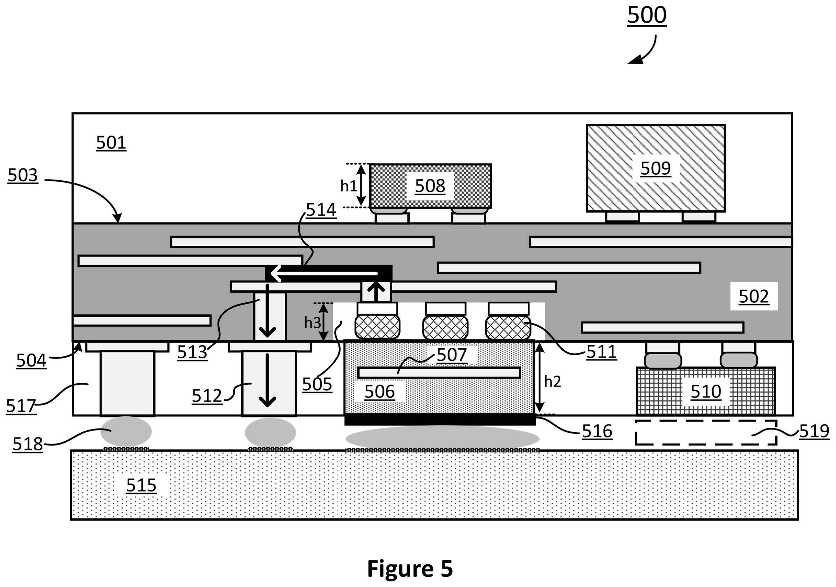

Figure 5 is a schematic cross-sectional view of a semiconductor device 500, in accordance with various embodiments of the subject technology. This diagram merely provides an example, which should not unduly limit the scope of the claims. One of ordinary skill in the art would recognize many variations, alternatives, and modifications. In various embodiments, semiconductor device 500 may include at least one of substrate 502, first circuit 508, second circuit 506, third circuit 509, fourth circuit 510, first cavity 505, metal post 512, and/or the like.

In some implementations, semiconductor device 500 includes substrate 502, which may include first side 503 and second side 504. First side 503 may be positioned opposite second side 504. Depending on the implementation, first side 503 may serve as the primary surface for the mounting of various circuits and components, such as first circuit 508 and/or third circuit 509. For instance, first circuit 508 may be characterized by a first thickness (e.g., h1), which may be less than or equal to 80 um. First circuit 508 may include, without limitation, microcontrollers, logic circuits, memory devices, sensor modules, processing units, and/or the like. Third circuit 509 may include a passive component. Examples of passive components may include, without limitation, resistors, capacitors, inductors, transformers, and/or the like.

In various embodiments, semiconductor device 500 further includes layer 501, which may be coupled to first circuit 508 and/or third circuit 509. For instance, layer 501 includes a molding material. Layer 501 may be configured to encapsulate electronic components (e.g., first circuit 508, third circuit 509), protecting them from physical damage, moisture, dust, and other environmental factors.

In various implementations, semiconductor device 500 may further include second circuit 506, which may be coupled to second side 504. Second circuit 506 may include an RF component. In some examples, second circuit 506 may be characterized by a second thickness (e.g., h2) greater than the first thickness. For instance, the second thickness may be greater than or equal to 80 um. In some cases, second circuit 506 may include seal space gap 507, which provides a buffer or clearance that ensures proper mechanical and functional performance between the internal components of second circuit 506.

In some embodiments, second side 504 further includes first cavity 505. Second circuit 506 may be positioned within first cavity 505. First cavity 505 may be characterized by a first depth (e.g., h3), which may be greater than 20 um and less than 120 um. First cavity 505 may be configured to provide additional vertical space, allowing second circuit 506 to be at least partially embedded within substrate 502 without increasing the overall thickness of semiconductor device 500. In some implementations, second circuit 506 may be coupled to substrate 502 via first connection 511. Examples of connections may include, without limitation, solder joints, wire bonds, vias, flip-chip bonds, and/or thermally conductive adhesives, and/or the like.

In various embodiments, semiconductor device 500 further includes fourth circuit 510 coupled to second side 504. Fourth circuit 510 may include, without limitation, microcontrollers, logic circuits, memory devices, sensor modules, processing units, and/or the like.

According to some embodiments, substrate 502 may further include one or more vias (e.g., vias 513 and 514) that serve as conductive pathways for signal transmission or thermal dissipation. Via 513 may be coupled to metal post 512 and provide vertical connections between the layers of substrate 502. Via 514 may include a lateral via, configured to route signals and dissipate heat horizontally within substrate 502. The combination of vertical and lateral vias enhances the overall thermal management of semiconductor device 500, ensuring effective heat transfer from the RF components (e.g., second circuit 506) while maintaining the integrity and performance of other components.

In some embodiments, metal post 512 may be coupled to second side 504 and serve as a thermal or mechanical support structure, facilitating heat dissipation or ensuring the secure placement of components. For instance, metal post 512 may be configured to route heat generated by second circuit 506 to external heat sinks or a motherboard (e.g., motherboard 515).

In various implementations, semiconductor device 500 further includes layer 516, which may be coupled to second circuit 506. For instance, layer 516 may be configured to couple second circuit 506 to motherboard 515. Layer 516 may include a metallization layer that enhances the thermal conduction path from second circuit 506 to motherboard 515. For example, layer 516 may include, without limitation, materials such as copper, silver, nickel, gold, or other conductive materials. This metallization layer may enable direct soldering between second circuit 506 and motherboard 515, providing a stable and secure electrical and mechanical connection. The direct soldering enabled by layer 516 may reduce thermal resistance, enabling heat to dissipate more efficiently from second circuit 506 into motherboard 515. Furthermore, layer 516 may also improve the structural integrity of the semiconductor package by providing an additional bonding point between semiconductor device 500 and motherboard 515. Layer 516 may also be patterned in various shapes and sizes, for example, one or more rectangles, circles, or other shapes.

In various embodiments, semiconductor device 500 further includes layer 517, which may be coupled to second side 504. For instance, layer 517 includes a molding material. Layer 517 provides an encapsulation for components positioned on second side 504 (e.g., second circuit 506, fourth circuit 510, metal post 512), protecting them from physical damage, moisture, dust, and other environmental factors. In some cases, layer 516 may protrude above a surface of layer 517 and provide an additional connection point between second circuit 506 and other components.

In some implementations, semiconductor device 500 further includes layer 518, which may be coupled between layer 517 and motherboard 515. Layer 518 may include various materials, such as thermally conductive adhesives, solder, epoxy resins, or other bonding materials designed to improve thermal conduction and mechanical stability. Layer 518 may be configured to facilitate mechanical stability and enhance thermal conductivity between the semiconductor device 500 and motherboard 515.

In some embodiments, air gap 519 may exist between fourth circuit 510 and motherboard 515. This air gap provides thermal isolation for fourth circuit 510, preventing direct heat transfer to motherboard 515. By maintaining the air gap, the design ensures that the heat generated by fourth circuit 510 does not interfere with the thermal management of other components, allowing for precise control of heat flow and reducing the risk of heat transfer between the two components.

While the above is a full description of the specific embodiments, various modifications, alternative constructions and equivalents may be used. Therefore, the above description and illustrations should not be taken as limiting the scope of the subject technology which is defined by the appended claims.
The following are further embodiments of the invention:
1. An apparatus comprising:
   a substrate comprising a first side and a second side, the first side being opposite the second side, and the second side comprising a first cavity;
   a first circuit coupled to the first side, the first circuit being characterized by a first thickness; and
   a second circuit positioned within the first cavity, the second circuit comprising a radio frequency (RF) component, the second circuit being characterized by a second thickness, the second thickness being greater than the first thickness;
   wherein the first cavity is characterized by a first depth, the first depth is less than or equal to the second thickness.
2. The apparatus of Embodiment 1, wherein the second thickness is greater than or equal to 80 um.
3. The apparatus of Embodiment 1, wherein the RF component comprises at least one of a bulk acoustic wave (BAW) filter, a film bulk acoustic resonator (FBAR), or a surface acoustic wave (SAW) filter.
4. The apparatus of Embodiment 1, wherein the first depth is greater than 20 um and less than 120 um.
5. The apparatus of Embodiment 1, further comprising a third circuit coupled to the first side, the third circuit comprising a passive component.
6. The apparatus of Embodiment 5, wherein the first side further comprises a second cavity, and the third circuit is positioned within the second cavity.
7. The apparatus of Embodiment 1, further comprising a first layer coupled to the second circuit, the first layer being configured to couple the second circuit to a motherboard.
8. The apparatus of Embodiment 1, wherein the substrate comprises a first via coupled to the second circuit, the first via is configured to direct heat away from the second circuit.
9. The apparatus of Embodiment 1, wherein the second circuit is coupled to the substrate via a first connection.
10. An apparatus comprising:
   a substrate comprising a first side and a second side, the first side being opposite the second side;
   a first circuit coupled to the first side, the first circuit being characterized by a first thickness; and
   a second circuit coupled to the second side, the second circuit comprising a radio frequency (RF) component, the second circuit being characterized by a second thickness, the second thickness being greater than the first thickness;
   wherein the second thickness is greater than or equal to 80 um.
11. The apparatus of Embodiment 10, wherein the second side comprises a first cavity characterized by a first depth less than or equal to the second thickness.
12. The apparatus of Embodiment 11, wherein the first depth is greater than 20 um and less than 120 um.
13. The apparatus of Embodiment 11, wherein the second circuit is positioned within the first cavity.
14. The apparatus of Embodiment 10, wherein the RF component comprises at least one of a bulk acoustic wave (BAW) filter, a film bulk acoustic resonator (FBAR), or a surface acoustic wave (SAW) filter.
15. The apparatus of Embodiment 10, further comprising a third circuit coupled to the first side, the third circuit comprising a passive component.
16. An apparatus comprising:
   a substrate comprising a first side and a second side, the first side being opposite the second side, and the second side comprising a first cavity;
   a first circuit coupled to the first side, the first circuit being characterized by a first thickness; and
   a second circuit positioned within the first cavity, the second circuit comprises a radio frequency (RF) component, the second circuit being characterized by a second thickness, the second thickness being greater than the first thickness;
   wherein the first cavity is characterized by a first depth greater than or equal to 20 um.
17. The apparatus of Embodiment 16, wherein the second thickness is greater than or equal to 80 um.
18. The apparatus of Embodiment 16, wherein the RF component comprises at least one of a bulk acoustic wave (BAW) filter, a film bulk acoustic resonator (FBAR), or a surface acoustic wave (SAW) filter.
19. The apparatus of Embodiment 16, wherein the first depth is less than or equal to 120 um.
20. The apparatus of Embodiment 16, wherein the second circuit is coupled to the substrate via a first connection

## Claims

1. An apparatus comprising:
a substrate comprising a first side and a second side, the first side being opposite the second side, and the second side comprising a first cavity;
a first circuit coupled to the first side, the first circuit being **characterized by** a first thickness; and
a second circuit positioned within the first cavity, the second circuit comprising a radio frequency (RF) component, the second circuit being **characterized by** a second thickness, the second thickness being greater than the first thickness;
wherein the first cavity is **characterized by** a first depth, the first depth is less than or equal to the second thickness.

2. The apparatus of claim 1, wherein the second thickness is greater than or equal to 80 um.

3. The apparatus of claim 1 or 2, wherein the first depth is greater than 20 um and less than 120 um.

4. The apparatus of any preceding claim, further comprising a third circuit coupled to the first side, the third circuit comprising a passive component,
in particular, wherein the first side further comprises a second cavity, and the third circuit is positioned within the second cavity.

5. The apparatus of any preceding claim, further comprising a first layer coupled to the second circuit, the first layer being configured to couple the second circuit to a motherboard.

6. The apparatus of any preceding claim, wherein the substrate comprises a first via coupled to the second circuit, the first via is configured to direct heat away from the second circuit.

7. The apparatus of any preceding claim, wherein the second circuit is coupled to the substrate via a first connection.

8. An apparatus comprising:
a substrate comprising a first side and a second side, the first side being opposite the second side;
a first circuit coupled to the first side, the first circuit being **characterized by** a first thickness; and
a second circuit coupled to the second side, the second circuit comprising a radio frequency (RF) component, the second circuit being **characterized by** a second thickness, the second thickness being greater than the first thickness;
wherein the second thickness is greater than or equal to 80 um.

9. The apparatus of claim 8, wherein the second side comprises a first cavity **characterized by** a first depth less than or equal to the second thickness.

10. The apparatus of claim 9, wherein the first depth is greater than 20 um and less than 120 um, and/or
wherein the second circuit is positioned within the first cavity.

11. The apparatus of any of claims 8 to 10, further comprising a third circuit coupled to the first side, the third circuit comprising a passive component.

12. An apparatus comprising:
a substrate comprising a first side and a second side, the first side being opposite the second side, and the second side comprising a first cavity;
a first circuit coupled to the first side, the first circuit being **characterized by** a first thickness; and
a second circuit positioned within the first cavity, the second circuit comprises a radio frequency (RF) component, the second circuit being **characterized by** a second thickness, the second thickness being greater than the first thickness;
wherein the first cavity is **characterized by** a first depth greater than or equal to 20 um.

13. The apparatus of claim 12, wherein the second thickness is greater than or equal to 80 um, and/or
wherein the first depth is less than or equal to 120 um.

14. The apparatus of claim 12 or 13, wherein the second circuit is coupled to the substrate via a first connection.

15. The apparatus of any preceding claim, wherein the RF component comprises at least one of a bulk acoustic wave (BAW) filter, a film bulk acoustic resonator (FBAR), or a surface acoustic wave (SAW) filter.
